(19) Europäisches Patentamt

European Patent Office

Office européen des brevets

(11) **EP 0 977 052 B1**

(12) **EUROPEAN PATENT SPECIFICATION**

(45) Date of publication and mention
of the grant of the patent:
**02.10.2002 Bulletin 2002/40**

(51) Int Cl.⁷: **G01S 13/89**, G01S 7/02,
G01R 31/312, G01R 29/08,
G01R 23/163

(21) Application number: **99203842.2**

(22) Date of filing: **12.01.1995**

(54) **Non-contact type wave signal observation apparatus**

Berührungslose Beobachtungsvorrichtung von Wellensignalen

Appareil d'observation d'un signal sans contact

(84) Designated Contracting States:
**DE FR GB NL SE**

(30) Priority: **12.01.1994 JP 157494**
**12.01.1994 JP 157594**
**13.01.1994 JP 190494**
**19.01.1994 JP 410794**
**21.01.1994 JP 540294**

(43) Date of publication of application:
**02.02.2000 Bulletin 2000/05**

(62) Document number(s) of the earlier application(s) in
accordance with Art. 76 EPC:
**95400057.6 / 0 667 538**

(73) Proprietor: **Advantest Corporation**
**Nerima-ku, Tokyo 179-0071 (JP)**

(72) Inventor: **Kitayoshi, Hitoshi**
**Tokyo (JP)**

(74) Representative: **Joly, Jean-Jacques et al**
**Cabinet Beau de Loménie**
**158, rue de l'Université**
**75340 Paris Cédex 07 (FR)**

(56) References cited:
**EP-A- 0 140 539          EP-A- 0 555 099**
**FR-A- 2 096 730**

**Description**

FIELD OF THE INVENTION

The invention relates to non-contact type wave signal observation apparatus. More particularly, the invention relates to a spatial electromagnetic wave analysis apparatus which measures properties, such as strength, axial ratio, direction of axes, axial inclination etc., of spatial polarized wave vectors of spatial polarized electromagnetic waves which propagate, are scattered, or are present in any fashion.

BACKGROUND OF THE INVENTION

There shall first be described the prior art relating to the present invention.
"Waste", or "leakage", electromagnetic waves are radiated from an electromagnetic wave propagation environment, for example by compound scattering when an electromagnetic wave propagates in a non-uniform medium, and, in the past, these leakage electromagnetic waves have been measured as described below.
That is, the strength of an electromagnetic wave component having one particular type or direction of polarisation was measured using an antenna, such as a Yagi antenna, helical antenna or horn antenna, capable of receiving just that one type of polarised signal. More particularly, a Yagi antenna was only suitable for receiving linearly polarized electromagnetic waves, and helical antennas were only suitable for receiving circularly polarized electromagnetic waves. The observable polarization information was limited by the antenna used for the observation. However, in general, electromagnetic waves having different types of polarization exist in the observation space. In order to obtain the full complement of information it is necessary to detect electromagnetic waves such as horizontally polarized waves, vertical polarized plane waves, right-handed polarized waves and left-handed polarized waves and to make a total analysis of the detected signals.
Furthermore, up until now it has been difficult to obtain a spatial distribution image.

SUMMARY OF THE INVENTION

The present invention provides a spatial electromagnetic wave analysis apparatus in which an electromagnetic wave is received at each observation point on an observation plane by a pair of orthogonally-arranged antennas each having a figure-of-eight beam reception pattern. The output signal of each of the pair of antennas is respectively convened into a complex signal. Moreover, a reference signal is obtained and converted into a complex reference signal - this signal will serve to define a reference phase. The complex signals derived from the received orthogonal polarization components at each observation point on the observation plane are divided by the complex reference signal so as to produce interference data. Hologram reconstruction calculations of the observation plane are performed on the respective interference data to produce, for each observation point (u,v), orthogonal components Ha(u,v) and Hb(u,v) which are taken to be the vertical and horizontal components of the polarized wave vector of an elliptically polarized wave. Preferably, Ha(u,v) and Hb(u,v) are displayed to indicate the strength of the polarized wave vector, together with display of the axial ratio, direction of the axis, inclination etc. for each observation point.

BRIEF DESCRIPTION OF THE DRAWINGS

Fig.1 is a block diagram showing an embodiment of a spatial electromagnetic wave analysis apparatus according to the present invention.
Fig.2 shows an example of an image which could be produced using the apparatus of Fig.1.
Fig.3 is a block diagram showing an embodiment of a complex wave interference information display apparatus which may be used to display data obtained using the spatial electromagnetic wave analysis apparatus according to the present invention.
Fig.4 shows an example of results displayed using the apparatus of Fig.3.
Fig.5 is a block diagram showing two-dimensional interference data observation means useable to furnish data for display by the display apparatus according to Fig.3.

DESCRIPTION OF THE PREFERRED EMBODIMENTS

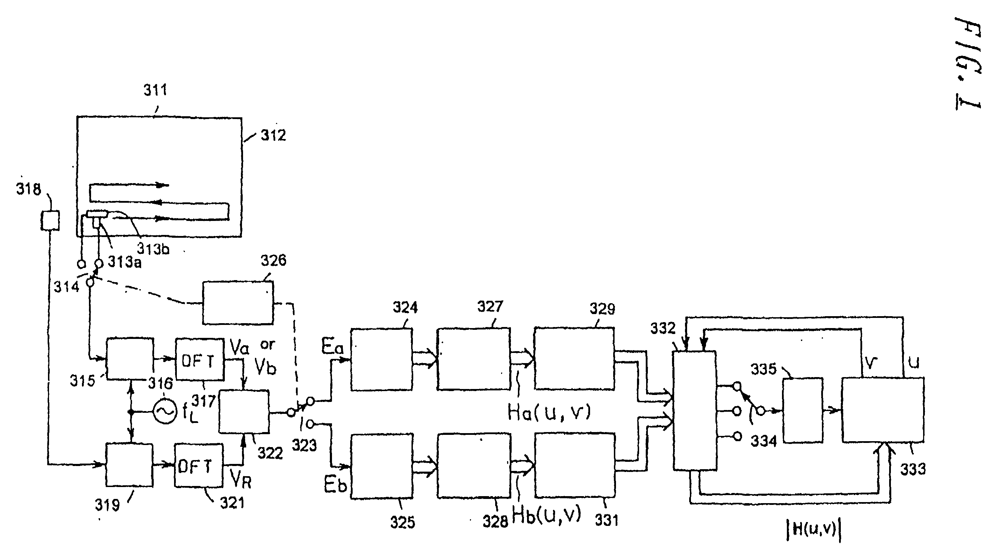

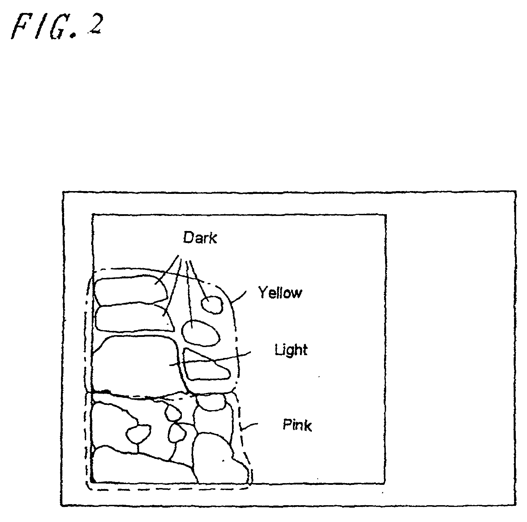

The present invention is explained below referring to Figs.1 and 2.
A preferred embodiment of spatial electromagnetic wave analysis apparatus according to the present invention is shown in Fig.1. An electromagnetic wave is received at a plurality of observation points on an electromagnetic wave observation plane 311 by scanning-antenna receiving means 312. In the scanning-antenna receiving means, there is used at least one pair of antennas 313a, 313b (such as a pair of a loop antenna and a dipole antenna). Each antenna of the pair has a figure-of-eight beam reception pattern, unlike antennas which can receive only one polarization mode, and the antennas of the pair are arranged orthogonally with respect to each other.

Either, an antenna pair 313a, 313b is moved to each observation point on the observation plane and the received output is measured, or an array of antenna pairs is used having an antenna pair at each observation point, the antenna pairs being selectively controlled in turn to output received signals.

The pair of received signals output by antennas 313a, 313b in respect of each observation point are converted into complex signals Va,Vb. For example, a switch 314 selectively outputs the signals produced by antennas 313a and 313b and supplies them to a frequency converter 315, coupled to a local oscillator 316 outputting a signal of frequency $f_L$, which converts them to intermediate frequency signals. The intermediate frequency signals are respectively subjected to a discrete Fourier transform (DFT) in discrete Fourier transform unit 317 so as to produce the complex signals Va(x,y) and Vb(x,y), which correspond respectively to the outputs of antennas 313a and 313b in respect of observation point (x,y).

A fixed antenna 318 outputs a reference signal which is used to provide a phase reference for the signals received by antennas 313a and 313b. The reference signal output by fixed antenna 318 is converted into a complex signal $V_R$ by being frequency converted in a frequency converter 319 (which converts it into an intermediate frequency signal using the output from local oscillator 316) and subjected to a discrete Fourier transform by discrete Fourier transform unit 321.

The pair of complex signals Va(x,y), Vb(x,y) for each observation point are each divided by the reference complex signal $V_R$ by an interferometer 322 to produce interference data Ea(x,y), Eb(x,y). These interference data signals are selectively fed to corresponding interference data memories 324, 325 via a switch 323. A control unit 326 uses, as the address for storing the interference data for a given observation point (x,y) in the interference data memories 324, 325, information identifying that observation point (x,y). Moreover, control unit 326 controls operation of the switches 314, 323.

Interference data Ea(x,y), Eb(x,y) is read out of the interference data memories 324, 325 and subjected by hologram reconstruction units 327, 328 to hologram reconstruction calculations of the electromagnetic wave observation plane, according to the following equations:

$$Ha(u,v) = \int \int Ea(x,y) \exp\{-j2\pi (ux + vy)\} \, dx \, dy$$

$$Hb(u,v) = \int \int Eb(x,y) \exp\{-j2\pi (ux + vy)\} \, dx \, dy \quad (1),$$

where u and v are respective azimuth and elevation angles of a point under observation as seen from the point (x,y) on the observation plane 311.

The results Ha(u,v), Hb(u,v) of these hologram reconstruction calculations are memorized in holographic memories 329, 331, respectively. These hologram reconstruction results Ha(u,v), Hb(u,v) are assumed to be respective vertical and horizontal components of an elliptically polarized electromagnetic wave. The polarized wave vector Hab (u,v,$\varphi$) of this wave is calculated, for each observation point (u,v), by a polarization calculation unit 332 according to the following equation:

$$Hab(u,v, \varphi) = Ha(u,v)\cos\varphi + Hb(u,v)\sin\varphi \quad (2)$$

The polarized wave vector Hab is equal to the horizontal component Hb(u,v) when $\varphi = \pi/2$ and is equal to the vertical component Ha(u,v) when $\varphi = 0$. The angles $\varphi_{MA}$ and $\varphi_{MI}$ at which the absolute value of the polarized wave vector becomes a maximum and a minimum, respectively, are determined for each observation point (u,v). $|Hab(u,v, \varphi_{MA})|$ is a major axis of the elliptically polarized electromagnetic wave at the observation point (u,v) and $|Hab(u,v,\varphi_{MI})|$ is the minor axis of the elliptically polarized wave. Therefore, the axial ratio AR(u,v) of the elliptically polarized wave is given by the following equation:

$$AR(u,v) = |Hab(u,v,\varphi_{MA})| \, / \, |Hab(u,v,\varphi_{MI})| \quad (3)$$

When the axial ratio is equal to 1 this indicates a circularly polarized electromagnetic wave. When the axial ratio is equal to infinity then this indicates a linearly polarized electromagnetic wave.

Furthermore, the inclination $\theta(u,v)$ (the orientation of the polarized wave vector in the plane perpendicular to the direction in which the elliptically polarized wave progresses) is obtained as a difference between the phase of the vertical component Ha(u,v) and the phase of the horizontal component Hb(u,v).

Polarization calculation unit 332 can calculate any or all of the following parameters from the electromagnetic wave vectors Hab(u,v,$\varphi$) of each observation point: axial ratio AR(u,v); rotating angle (major axis angle), $\varphi_{MA}$; strength (major axis), |Hab(u,v,$\varphi_{MA}$)|; and inclination to propagation direction $\theta(u,v)$. These parameters of polarized wave vectors Hab are displayed on a display 333 in relation to the corresponding observation points (u,v). For example, one of the parameters axial ratio AR(u,v), rotating angle $\varphi_{MA}(u,v)$ and inclination to propagation direction $\theta(u,v)$ is selected by a switch 334 and input to a hue converter 335. The hue converter 335 converts the selected parameter into a hue signal corresponding to its magnitude and displays it on display 333 (which, in this case, is a colour display). So the colours displayed on the colour display unit 333 are controlled by the value of the selected output (axial ratio, rotating angle and inclination), and the brightnesses displayed on the colour display unit 333 are controlled according to strength |H(u,v,$\varphi_{MA}$)|.

Fig.2 shows an example of an image which could be displayed on colour display 333 when the observation plane observes waste radiation leaking from electronic equipment and switch 334 selects the rotating angle parameter, $\varphi_{MA}$. It is to be understood that this display indicates waste radiation leaking from the left-hand part of a piece of electronic equipment with the major axis of the elliptically polarized radiation being on its side, that is, lying in a horizontal direction, in the pink coloured image at the lower left of the display screen. The yellow-coloured image above the pink image is understood as indicating that the major axis is disposed lengthways, that is, in the vertical direction, the bright lower portion of this yellow image indicates that there the electromagnetic wave strength is strong, and the dimmer upper portion of the yellow image indicates weaker wave strength.

The switches 314, 323 of the Fig.1 apparatus described above may be omitted. In such a case a pair of frequency converters may be provided to convert the respective outputs from the antennas 313a, 313b, a pair of DFT units would transform the intermediate frequency signals and a pair of interferometers 322 would operate on the transformed signals. The outputs of the interferometers 322 would be fed to the respective interference data memories 324, 325. The outputs of the interference data memories may be switched, the read-out data supplied to a single hologram reconstruction unit, and the results of the hologram reconstruction calculations may be switched to the holographic memories 329, 331.

In the case where the spatial electromagnetic wave analysis apparatus is used to observe waste radiation from electronic equipment having only one signal source, the fixed antenna 318 generating the reference signal may be omitted. In such a case, in order to obtain the desired complex signals, two outputs of quadrature-detected received signals are treated as real and imaginary parts of the respective complex signal. In this case, in order to determine each frequency component, the local frequency used in the quadrature detection is changed so as successively to take a plurality of different discrete values. Furthermore, hologram reconstruction calculations relating to locations (u,v) close to the observation plane 311 may also be performed according to other known equations.

According to the invention, electromagnetic waves are received at each observation point of the electromagnetic wave observation plane by a pair of antennas having mutually orthogonal figure of eight beam patterns. Two received signals are converted into complex signals and the complex signals are converted using hologram reconstruction. By assuming the results to be horizontal and vertical components of an elliptically polarized wave vector, the states of polarization of electromagnetic waves of the electromagnetic wave source may be determined.

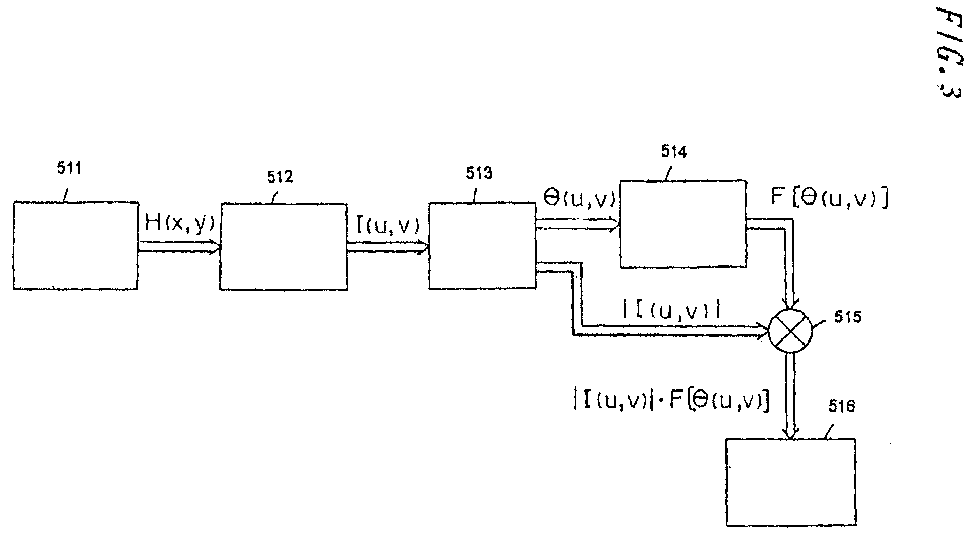

Fig.3 shows a first preferred embodiment of display apparatus for complex wave information which may be used to display data obtained by the spatial electromagnetic wave analysis apparatus according to the invention. Two-dimensional interference data H(x,y) regarding electromagnetic waves in three-dimensional space is obtained from interference data observation means 511. In this example, positions (x,y) in the observation plane are designated using an orthogonal co-ordinate system. An example of a possible construction of the interference data observation means 511 is given later on. A hologram reconstruction unit 512 performs hologram reconstruction calculations using the two-dimensional interference data H(x,y). The Fraunhofer transform is used in the hologram reconstruction calculations, according to the following equation:

$$I(u,v) = \int \int H(x,y) \exp\{-2j\pi(ux+vy)\} \, dx \, dy \qquad (4),$$

where u and v are the azimuth angle and the elevation angle, respectively, when viewed from point (x,y) on the observation plane. For instance, at observation points (x,y) on the observation plane spaced apart from the electromagnetic wave source by a distance Z, two-dimensional interference data H(x,y) are observed which represent the data from the source subjected to the transfer function of $\exp\{(j\pi/\lambda Z)(x^2+y^2)\}$. If hologram reconstruction calculations are performed on this two-dimensional interference data H(x,y) the above propagation function becomes $j\lambda Z \exp\{-j\pi\lambda Z$

$(u^2+v^2)\}$. In addition, the Fourier integral of the observation plane is convolved into this.

A co-ordinate converter 513 converts the result of such hologram reconstruction calculations from orthogonal co-ordinates to polar co-ordinates I(u,v). That is, the real part and the imaginary part of I(u,v) are calculated. The amplitude and the phase of I(u,v) which corresponds to these real part and imaginary parts are also calculated. A hue converter 514 converts the phase information θ(u,v) of the co-ordinate-converted data into a colour signal F[θ(u,v)] of a corresponding hue. A multiplication unit 515 modulates the colour signal F[θ(u,v)] by multiplying it by the amplitude information |I(u,v)| of the coordinate-converted data from co-ordinate converter 513. The modulated output |I(u,v)| •F [θ(u,v)] is displayed on a colour display unit 516 as a colour image in the plane of u and v.

For an electromagnetic wave source which is close to the observation plane, the observed amplitude information |I(u,v)| of I(u,v) is large and drops off rapidly towards the periphery of the image corresponding to the source and the observed phase information θ(u,v) changes comparatively slowly while going from the center to the surrounding of the image corresponding to the source. On the other hand, for an electromagnetic wave source which is further away from the observation plane, the observed amplitude information of I(u,v) is small and weakens comparatively slowly while going from the center to the periphery of the image corresponding to the source and the observed phase information changes comparatively rapidly while going from the center to the surrounding of the image corresponding to the source.

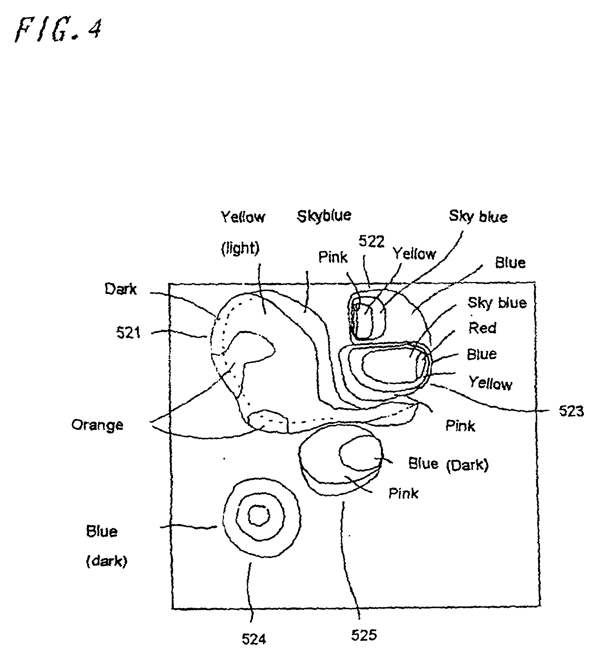

Fig.4 is an example of an image displayed on the display unit 516 when waste/leakage radiation from a piece of electronic equipment is observed at the observation plane by the apparatus of the invention, complex two-dimensional electromagnetic wave interference data is obtained and processing is performed as in the case of Fig.3. The large image 521 on the left upper part of the display is bright, with the brightness reducing rapidly towards the periphery of the image, and the stripes of colour in the image are wide meaning that the observed phase information changes comparatively slowly while going from the center to the surrounding of the image. Therefore, it is understood that image 521 is near the observation plane. Moreover, the colour stripes look wider on the left-hand side than on the right-hand side of image 521 and so an electromagnetic wave of this waste radiation is judged to radiate from the left as seen in the figures.

Image 522, to the right and slightly above image 521 on the image display, is smaller than image 521, has weak brightness and the colour striping is detailed. That is, the phase changes rapidly from the center of the image towards the edges and the striping at the right of the image is coarser than that at the left. That is, it is deduced that image 522 corresponds to a radiation source which is further away and to the right of that corresponding to image 521.

Image 523, between the lower right-hand portion of image 521 and image 522, is slightly larger and brighter than image 522 and the thickness of the colour stripe is about the same as for image 522. Therefore, the radiation source of image 521 is judged to be located at about the same distance as image 522 from the observation plane. However, image 523 corresponds to a slightly stronger source and, from the colour striping, it is understood that this source is radiating to the left because the colour stripes on the right-hand side are finer than those on the left-hand side.

Image 524 spaced apart from image 521 has light and dark portions, the maxilla of the colour stripes are only just fatter than that of the image 522. Therefore, it is judged to correspond to a weak radiation source at a distance which is the same or more than that of the images 522, 523 from the observation plane in the direction perpendicular to the observation plane.

Similarly, image 525, between image 521 and image 524, is judged to correspond to a weak radiation source, radiating to the left, which is comparatively near the observation plane.

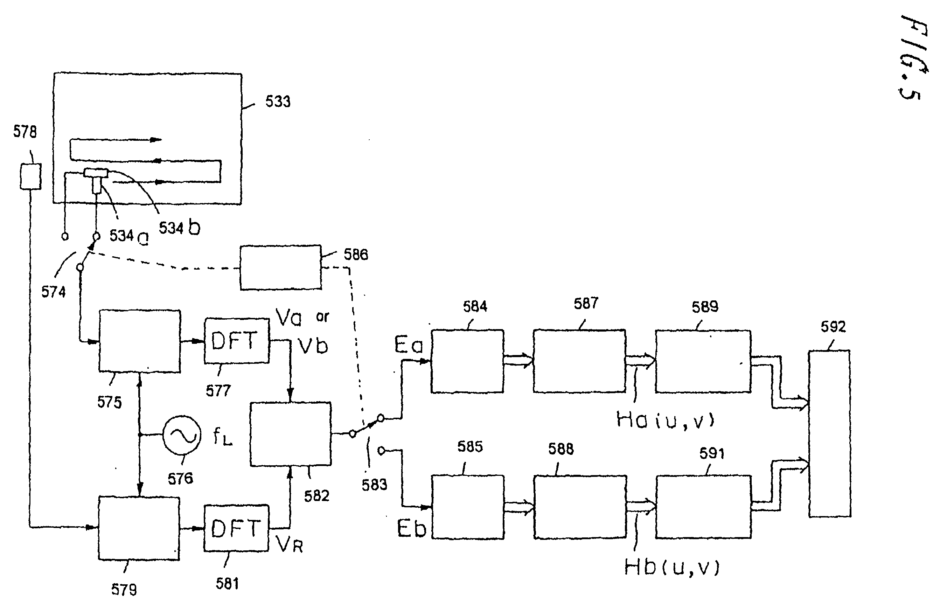

Next, a concrete example of the two-dimensional interference data observation means 511, here used to observe propagating in space waste/leakage electromagnetic radiation from electronic equipment, suitable for use with the image display unit of Fig.3 will now be described with reference to Fig.5. Antenna-element pair 534a, 534b having mutually orthogonal figure-of-eight beam patterns receive, as in the above-described case, radiation at each observation point (x,y) of the observation plane 533. The received outputs of antennas 534a, 534b are switchably selected by a switch 574 and are supplied to a frequency converter 575, where they are respectively converted to intermediate frequency (IF) signals using a local signal of frequency $f_L$ from local oscillator 576. Each IF signal is subjected to a conversion by a discrete Fourier transform unit 577. As a result, complex signals Va(x,y) and Vb(x,y) are obtained which correspond to the signals received by antennas 534a and 534b at each observation point on the observation plane 533.

Additionally, fixed antenna 578 is provided, the output of which is a reference signal which becomes a reference phase for the signals received by antennas 534a and 534b, this reference signal too is converted to a complex signal. That is, the output of fixed antenna 578 is converted to an IF signal in a frequency converter 579 using the local signal from local oscillator 576, a discrete Fourier transform is performed on this convened IF signal by discrete Fourier transform unit 581 and reference complex signal $V_R$ is obtained as a result.

The complex signals Va(x,y) and Vb(x,y) for each observation point (x,y) are divided in interferometer 582 by reference complex signal $V_R$ to produce two-dimensional interference data Ha(x,y) and Hb(x,y) respectively. These interference data divided in interferometer 582 by reference complex signal $V_R$ to produce two-dimensional interference data Ha(x,y) and Hb(x,y) are switchably selected by switch 583 and are memorized in interference data memories 584, 585. In this example, information indicative of the observation point (x,y), designated by control unit 586, is used as the address signal for the memories 584, 585. Moreover, control unit 586 controls the switches 574 and 583.

Hologram reconstruction calculations of the observation plane 533 are performed on interference data Ha(x, y) and Hb(x,y) by hologram reconstruction calculation units 587, 588 according to the following equations:

$$Ia(u,v) = \int \int Ha(x,y) \exp\{-j2\pi (ux+vy)\} \, dx \, dy$$

$$Ib(u,v) = \int \int Hb(x,y) \exp\{-j2\pi (ux+vy)\} \, dx \, dy \tag{5}$$

Ia(u,v) and Ib(u,v) resulting from these hologram reconstruction calculations are memorized in holographic memories 589, 591 respectively. In this case, it is assumed that the detected electromagnetic waves are elliptically polarized, that the axial ratio, etc., of polarization of the polarized wave vector Iab(u,v,φ) can be measured and that the hologram reconstruction results Ia(u,v) and Ib(u,v) are the vertical and horizontal components of the elliptically polarized wave vector. A polarization calculation unit 592 determines the wave vector for each observation point (u,v) according to the following equation:

$$Iab(u,v) = Ia(u,v) \cos\varphi + Ib(u,v) \sin\varphi \tag{6}$$

That is, the polarized wave vector Iab is equal to the horizontal component Ib(u,v) when $\varphi = \pi/2$ and is equal to the vertical component Ia(u,v) when $\varphi = 0$.

For each observation point (u,v) values $\varphi_{MA}$ and $\varphi_{MI}$ are calculated at which the absolute value of the polarized wave vector Iab becomes a maximum and a minimum, respectively. $|Iab(u,v,\varphi_{MA})|$ is a major axis of the elliptically polarized electromagnetic wave at the observation point (u,v) and $|Iab(u,v,\varphi_{MI})|$ is the minor axis of the elliptically polarized wave. Therefore, the axial ratio AR(u,v) of the elliptically polarized wave is given by the following equation:

$$AR(u,v) = |Iab(u,v,\varphi_{MA})| \, / \, |Iab(u,v,\varphi_{MI})| \tag{7}$$

When the axial ratio AR(u,v) is equal to 1 this indicates a circularly polarized electromagnetic wave. When the axial ratio AR(u,v) is equal to infinity then this indicates a linearly polarized electromagnetic wave.

In addition, the inclination θ(u,v) in the direction in which the elliptically polarized wave progresses is obtained as a difference between the phase of vertical component Ia(u,v) and the phase of the horizontal component Ib(u,v).

The value $\varphi_{MA}$ at which the absolute value of the polarized wave vector Iab becomes a maximum is given by the following equation:

$$\varphi_{MA} = (1/2)\tan^{-1} \{2 \, |Ia(u,v)| \, |Ib(u,v)| \cos(\theta (u,v)) / (|Ia(u,v)|^2 + |Ib(u,v)|^2)\} \tag{8}$$

Because this information is a phase it is input to hue converter 514. Because the axial ratio AR(u,v) is not phase information, an angle of elliptical aperture τ(u,v), which corresponds to phase, is calculated according to the following equation:

$$\tau(u,v) = (1/2)\sin^{-1} \{2 \, |Ia(u,v)| \, |Ib(u,v)| \sin(\theta (u,v)) / (|Ia(u,v)|^2 + |Ib(u,v)|^2)\} \tag{9}$$

Any of the parameters inclination θ(u,v), axial ratio AR(u,v) or rotating angle $\varphi_{MA}$ (major axis angle) can be selected and supplied to hue converter 514 of Fig.3, and strength (major axis) $|Ia(u,v,\varphi_{MA})|$ may be supplied to multiplication unit 515. In this case, co-ordinate conversion is performed beforehand from the orthogonal co-ordinates to polar co-ordinates.

With the above-described display apparatus, complex two-dimensional wave interference data can be displayed in a manner giving a feeling of distance in a direction at a right angle to the observation plane by converting the phase information into a hue signal and modulating the hue signal by amplitude information. That is, complex three-dimensional space can be displayed using two-dimensional computer graphics.

It is to be understood that the polarisation information, etc. calculated by apparatus according to the invention can be outputted in some manner other than image display discussed above. Thus, for example, the data can be output to a printer for printing in any desired form including, but not limited to, an image representation, numerical data, a graph or chart, etc.; to a memory device; to a further data processing device; etc.

**Claims**

1. A spatial electromagnetic wave analysis apparatus which receives spatial electromagnetic waves at a number of observation points of an electromagnetic wave observation plane (311), and analyzes states of electromagnetic waves on a target space, comprising:

   scanning-antenna receiving means (312) for receiving electromagnetic waves at said observation points by an antenna-element pair (313a,313b) with mutually orthogonal 8-figured beam patterns;
   complex signal converting means (314-317) for converting both received signals of said antenna-element pair (313a,313b) to complex signals respectively;
   reference signal receiving means (318) for receiving a reference signal which becomes a reference phase for said received signals;
   means (319,321) for converting said reference signal to a reference complex signal;
   means (322) for calculating interference data of orthogonal polarized wave components of said received signals, using complex signal divided by said reference complex signal;
   means (327,328) for calculating holograms using hologram reconstruction calculations of said interference data over said observation plane;
   means (332) for calculating polarized wave vectors where said holograms are vertical and horizontal components of elliptically polarized waves, at reconstructed analysis points on said target space; and
   display means (333) for displaying parameters of said polarized wave vectors at said reconstructed analysis points.

2. A spatial electromagnetic wave analysis apparatus according to claim 1 wherein said reference signal receiving means is composed of a fixed antenna (318).

3. A spatial electromagnetic wave analysis apparatus according to claims 1 or 2 wherein said complex signal converting means is composed of means (315,316) for converting said received signal to an IF signal and means (317) for converting said IF signal using the discrete Fourier transform.

4. A spatial electromagnetic wave analysis apparatus according to claims 1 to 3 wherein said display means (333) displays brightness modulated images according to strength of said polarized wave vectors and hue modulated images according to other parameters of said polarized wave vectors at said reconstructed analysis points, where said target space is mapped to display surface.

5. A spatial electromagnetic wave analysis apparatus according to claims 1 to 3 wherein said scanning-antenna receiving means (312) is composed of an array antenna of said antenna-element pair on said observation plane, and received signals of said array antenna are scanned then output.

6. A spatial electromagnetic wave analysis apparatus according to claims 1 to 3 wherein said scanning-antenna receiving means (312) is composed of a scanning antenna of said antenna-element pair which is scanned to specified positions on said observation plane, and received signals of said scanning antenna are output at specified positions.

**Patentansprüche**

1. Analysevorrichtung für räumliche elektromagnetische Wellen, die räumliche elektromagnetische Wellen an mehreren Beobachtungspunkten einer Beobachtungsebene (311) für elektromagnetische Wellen empfängt und die Zustände der elektromagnetischen Wellen in einem Zielraum analysiert, und die aufweist:

   - eine Abtastantennenempfangseinrichtung (312) zum Empfang elektromagnetischer Wellen an den Beobachtungspunkten durch ein Paar von Antennenelementen (313a, 313b) mit zueinander orthogonalen Peilachtstrahl-Empfangsmustern;

- Wandlereinrichtungen (314-317) für komplexe Signale zum Umwandeln der beiden empfangenen Signale von dem Paar von Antennenelementen (313a, 313b) in komplexe Signale;
- eine Bezugssignalempfangseinrichtung (318) zum Empfang eines Bezugssignals, das zu einer Bezugsphase für die empfangenen Signale wird;
- Mittel (319, 321) zur Umwandlung des Bezugssignals in ein komplexes Bezugssignal;
- Mittel (322) zur Berechnung der Interferenzdaten von orthogonal polarisierten Wellenkomponenten der empfangenen Signale, die ein komplexes Signal dividiert durch das komplexe Bezugssignal verwendet,
- Mittel (327, 328) zur Berechnung von Hologrammen, die Hologramm-Rekonstruktionsberechnungen der Interferenzdaten über der Beobachtungsebene verwenden;
- Mittel (332) zur Berechnung polarisierter Wellenvektoren, wobei die Hologramme senkrechte und waagrechte Komponenten von elliptisch polarisierten Wellen sind, an rekonstruierten Analysepunkten im Zielraum; und
- Anzeigemitteln (33) zur Anzeige von Parametern der polarisierten Wellenvektoren an den rekonstruierten Analysepunkten.

2. Analysevorrichtung für räumliche elektromagnetische Wellen nach Anspruch 1, bei der die Bezugssignalempfangseinrichtung aus einer festen Antenne (318) besteht.

3. Analysevorrichtung für räumliche elektromagnetische Wellen nach Anspruch 1 oder 2, bei der die Umwandlungseinrichtung für komplexe Signale aus Mitteln (315, 316) zur Umwandlung des empfangenen Signals in ein IF-Signal und Mitteln (317) zur Umwandlung des IF-Signals unter Verwendung der diskreten Fourier-Transformation besteht.

4. Analysevorrichtung für räumliche elektromagnetische Wellen nach den Ansprüchen 1 bis 3, bei der die Anzeigeeinrichtung (333) helligkeitsmodulierte Bilder entsprechend der Stärke der polarisierten Wellenvektoren und farbtonmodulierte Bilder entsprechend anderer Parameter der polarisierten Wellenvektoren an den rekonstruierten Analysepunkten anzeigt, wobei der Zielraum auf der Anzeigefläche abgebildet ist.

5. Analysevorrichtung für räumliche elektromagnetische Wellen nach den Ansprüchen 1 bis 3, bei der die Abtastantennenempfangseinrichtung (312) aus einer Array-Antenne des Paars von Antennenelementen auf der Beobachtungsebene besteht, und empfangene Signale dieser Array-Antenne abgetastet und dann ausgegeben werden.

6. Analysevorrichtung für räumliche elektromagnetische Wellen nach den Ansprüchen 1 bis 3, bei der die Abtastantennenempfangseinrichtung (312) aus einer Abtastantenne des Paars von Antennenelementen besteht, die zu spezifizierten Positionen auf der Beobachtungsebene bewegt wird, und empfangene Signale der Abtastantenne an spezifizierten Positionen ausgegeben werden.

## Revendications

1. Dispositif d'analyse d'onde électromagnétique spatiale qui reçoit des ondes électromagnétiques spatiales en un certain nombre de points d'observation d'un plan d'observation d'onde électromagnétique (311) et analyse des états des ondes électromagnétiques sur un espace cible, comprenant :

   un moyen de réception d'antenne à balayage (312) destiné à recevoir des ondes électromagnétiques auxdits points d'observation grâce à une paire d'éléments d'antennes (313a, 313b) présentant mutuellement des profils de faisceau orthogonaux en forme de chiffre 8,
   un moyen de conversion de signal complexe (314 à 317) destiné à convertir les deux signaux reçus de ladite paire d'éléments d'antennes (313a, 313b) en signaux complexes, respectivement,
   un moyen de réception de signal de référence (318) destiné à recevoir un signal de référence qui devient une phase de référence pour lesdits signaux reçus,
   un moyen (319, 321) destiné à convertir ledit signal de référence en un signal complexe de référence,
   un moyen (322) destiné à calculer des données d'interférence des composantes d'ondes polarisées orthogonales desdits signaux reçus, en utilisant un signal complexe divisé par ledit signal complexe de référence,
   un moyen (327, 328) destiné à calculer des hologrammes en utilisant des calculs de reconstitution d'hologramme desdites données d'interférence sur ledit plan d'observation,
   un moyen (332) destiné à calculer des vecteurs d'ondes polarisées où lesdits hologrammes sont des composantes verticale et horizontale des ondes polarisées de façon elliptique, aux points d'analyse reconstitués sur ledit espace cible, et
   un moyen d'affichage (333) destiné à afficher des paramètres desdits vecteurs d'ondes polarisées auxdits points d'analyse reconstitués.

2. Dispositif d'analyse d'onde électromagnétique spatiale selon la revendication 1, dans lequel ledit moyen de réception de signal de référence est composé d'une antenne fixe (318).

3. Dispositif d'analyse d'onde électromagnétique spatiale selon les revendications 1 ou 2, dans lequel ledit moyen de conversion de signal complexe est composé d'un moyen (315, 316) destiné à convertir ledit signal reçu en un signal à fréquence intermédiaire (FI) et un moyen (317) destiné à convertir ledit signal à fréquence intermédiaire en utilisant la transformation de Fourier discrète.

4. Dispositif d'analyse d'onde électromagnétique spatiale selon les revendications 1 à 3, dans lequel ledit moyen d'affichage (333) affiche des images à luminosité modulée conformément à une intensité desdits vecteurs d'ondes polarisées et des images à teinte modulée conformément à d'autres paramètres desdits vecteurs d'ondes polarisées auxdits points d'analyse reconstitués, où ledit espace cible est mappé sur une surface d'affichage.

5. Dispositif d'analyse d'onde électromagnétique spatiale selon les revendications 1 à 3, dans lequel ledit moyen de réception d'antenne à balayage (312) est composé d'une antenne en réseau de ladite paire d'éléments d'antennes sur ledit plan d'observation, et lesdits signaux reçus de ladite antenne en réseau sont balayés puis fournis en sortie.

6. Dispositif d'analyse d'onde électromagnétique spatiale selon les revendications 1 à 3, dans lequel ledit moyen de réception d'antenne à balayage (312) est composé d'une antenne à balayage de ladite paire d'éléments d'antennes qui réalise un balayage sur des positions spécifiées sur ledit plan d'observation et les signaux reçus de ladite antenne à balayage sont fournis en sortie à des positions spécifiées.

FIG. 1

FIG. 2

Dark

Yellow

Light

Pink

# FIG. 3

# FIG. 4

# FIG.5